# EUROPÄISCHE PATENTSCHRIFT

(11) **EP 2 850 652 B1**
(45) Veröffentlichungstag und Bekanntmachung des Hinweises auf die Patenterteilung: **08.07.2026**
(21) Anmeldenummer: 13722363.2
(22) Anmeldetag: 06.05.2013
(51) Int. Cl.: H10W 72/00, H10W 72/50, H10W 72/60, H10W 90/00

(54) **ELEKTRISCHE KONTAKTIERUNG FÜR HALBLEITER**
ELECTRIC CONTACT STRUCTURE FOR SEMICONDUCTORS
DISPOSITIF DE MISE EN CONTACT ÉLECTRIQUE POUR SEMI-CONDUCTEURS

(30) Priorität: 16.05.2012 DE 102012208251
(43) Veröffentlichungstag der Anmeldung: 25.03.2015
(73) Patentinhaber: Robert Bosch GmbH, 70442 Stuttgart (DE)
(72) Erfinder: GUENTHER, Michael, 70469 Stuttgart (DE)
(86) Internationale Anmeldenummer: PCT/EP2013/059367
(87) Internationale Veröffentlichungsnummer: WO 2013/171084

(56) Entgegenhaltungen:
- WO-A1-2005/071733
- WO-A1-2012/049893
- JP-A- 2011 204 968
- US-A1- 2004 217 488

## Beschreibung

### Stand der Technik

DE 10 2006 025 870 A1 bezieht sich auf ein mehrschichtiges Bond-Bändchen. Gemäß dieser Lösung ist ein Bonddraht als Bändchen ausgebildet und weist mindestens zwei Schichten, die aus unterschiedlichen Materialien gefertigt sind, auf. Die Schmelzpunkte der mindestens zwei Schichten sind voneinander verschieden. Des Weiteren ist die Biegesteifigkeit und/oder die Reißkraft und/oder die Dehnbarkeit der Schichten voneinander verschieden, ferner die Dicke der Schichten. Eine mittlere Schichtdicke der Schichten liegt etwa zwischen 1 nm und 200 nm, insbesondere zwischen 15 nm und 30 nm, bevorzugt zwischen 20 nm und 25 nm. Eine Bondverbindung zwischen zwei Kontaktflächen zeichnet sich dadurch aus, dass die Kontaktflächen mit mindestens einem als Bändchen ausgebildeten Bonddraht elektrisch miteinander verbunden, vorzugsweise ultraschallverschweißt sind.

DE 10 2006 025 867 A1 bezieht sich auf eine Bondverbindung sowie ein Verfahren zum Bonden zweier Kontaktflächen. Gemäß dieser Lösung weist eine Bondverbindung zwischen zwei Kontaktflächen mindestens zwei Bonddrähte auf, wobei die mindestens zwei Bonddrähte übereinander angeordnet und leitend miteinander verbunden sind. Ausschließlich der unterste Bonddraht ist unmittelbar mit den Kontaktflächen verbunden, vorzugsweise verschweißt. Die Bonddrähte sind miteinander verschweißt, vorzugsweise miteinander ultraschallverschweißt. Mindestens einer der Bonddrähte, vorzugsweise sämtliche Bonddrähte sind als Bändchen ausgebildet und weisen zumindest näherungsweise eine rechteckige Querschnittsfläche auf.

DE 10 2006 025 867 A1 bezieht sich des Weiteren auf ein Verfahren zum Bonden zweier Kontaktflächen. Unter Verwendung mindestens eines ersten und eines zweiten Bonddrahtes wird der erste Bonddraht mit den beiden Kontaktflächen gebondet und der zweite Bonddraht über dem ersten Bonddraht angeordnet und mit diesem gebondet.

Halbleiterbauelemente werden üblicherweise durch Löten oder andere stoffschlüssige Fügeverfahren, wie zum Beispiel Schweißen oder Ultraschallschweißen auf Schaltungsträgern montiert, um eine elektrische Funktionalität darzustellen. Eine weiterhin eingesetzte Methode, die Oberseite der Halbleiter, bei denen sich beispielsweise um Dioden, um MOSFET's, IGBT's handelt, und die zu kontaktieren sind, besteht in der Verwendung der Drahtbondtechnik bzw. der Bändchenbondtechnik. Gemäß dieser Verbindungsverfahren wird mittels ultraschallunterstütztem Verschweißen eine stoffschlüssige Verbindung zwischen der Oberseite des Halbleiters und einem Draht oder Bändchen hergestellt. Bei dem Draht oder dem Bändchen, was hierzu eingesetzt wird, handelt es sich um Aluminium- oder Kupferdrähte bzw. Bändchen. Das Ende des Drahtes bzw. des Bändchens wird an einer zweiten Fügestelle wiederum mit dem Schaltungsträger verbunden, um die gleiche Verdrahtungsebene zu erreichen.

Die Robustheit der elektrischen Schaltungen wird im Allgemeinen durch Zuverlässigkeitstests abgeprüft. Es hat sich herausgestellt, dass ein typisches und ein die Lebensdauer elektrischer Schaltungen begrenzendes Ausfallbild durch das Versagen der Verbindungsstelle zwischen dem Halbleiter einerseits und einem Aluminiumdraht bzw. einem Aluminiumbändchen andererseits vorliegt. Dies ist darin begründet, dass der thermische Ausdehnungskoeffizient von Aluminium bei 23 µm/(m*K) liegt, wohingegen der von dem Halbleitermaterial Silizium bei ca. 2 µm/(m*K). Aufgrund der unterschiedlichen thermischen Ausdehnungskoeffizienten der eingesetzten Materialien Silizium und Aluminium, tritt im thermomechanischen Wechselspiel eine Zerrüttung der Fügestelle Aluminium-Silizium auf. Die Zerrüttung der Fügestelle hat im Allgemeinen eine Erhöhung des elektrischen Widerstandes zur Folge. Durch die lokal auftretende Widerstandserhöhung treten - insbesondere bei hohen Strömen in Schaltungsträgern - Verlustleistungen auf, die eine erhebliche lokale Temperaturerhöhung bewirken und die im Extremfall zu einer Zerstörung der Anbindung, d.h. der Bondverbindung zwischen dem Halbleiter und der Bondverbindung führen können.

Das Versagen der Bondverbindung ist abhängig von dem verwendeten Draht- oder Bändchenmaterial (Kupfer, Aluminium), der Größe der Kontaktfläche auf dem Halbleiter sowie der angelegten Prüfbedingung (Temperatur). Hinsichtlich der Größe der Kontaktfläche auf dem Halbleiter ist zu erwähnen, dass eine entsprechende Mindestgröße dieser Kontaktfläche auf dem Halbleiter durch die benötigte Stromtragfähigkeit erzwungen wird.

Aus der Offenlegungsschrift WO2005071733 A1 ist eine elektrische Kontaktierung zwischen zwei Kontaktflächen bekannt, wobei die elektrische Kontaktierung bandförmig ausgeführt ist, und wobei die elektrische Kontaktierung als Sandwichaufbau beschaffen ist.

Die japanische Offenlegungsschrift JP2011-204968 A beschreibt eine Halbleiteranordnung mit verbesserter Zuverlässigkeit der Verbindungsstelle und reduzierter Belastung des Halbleiterelements. Die Lösung besteht in einer Metallverbindung, die aus mehreren übereinanderliegenden dünnen Metallschichten besteht, wobei diese an zwei Stellen elektrisch, aber nicht mechanisch miteinander verbunden sind.

Die veröffentlichte US-Patentanmeldung US 2004/0217488 A1 betrifft ein Verfahren zum Kontaktieren von Bändern an Halbleiterchips und Anschlüsse eines Gehäuses. Dabei wird Ultraschallschweißen verwendet, um ein oder mehrere flexible leitfähige Bänder an die Oberfläche des Chips anzuschließen.

Die veröffentlichte internationale Patentanmeldung WO 2012/049893 A1 beschreibt ein rechteckiges, silberbeschichtetes Kupferband für Hochtemperatur-Halbleiterbauelemente. Es besteht aus einer Schicht aus Silber und einem Kernband aus Kupfer.

Eine Wärmebehandlung nach dem Beschichten beseitigt eine stark verformte, feinkristalline Struktur.

### Darstellung der Erfindung

Erfindungsgemäß wird eine elektrische Kontaktierung eines Halbleiters vorgeschlagen unter Einsatz eines bändchenförmig ausgebildeten Kontaktes gemäss dem Produktanspruch 1 und dem Verfahrensanspruch 3.

Erfindungsgemäß ist der bändchenförmig ausgebildete Kontakt in Form eines Sandwiches aufgebaut. Anstatt durch Ultraschallschweißen wird der erfindungsgemäß vorgeschlagene bändchenförmige Kontakt in Sandwichaufbau durch einen

Festphasendiffusionsprozess aufgebracht. Als Festphasendiffusionsprozesse kommt erfindungsgemäß Sintern in Betracht. Anders als die Erfindung ist auch ein Diffusionslöten als der Festphasendiffusionsprozess denkbar. Der als Sandwichaufbau ausgebildete bändchenförmige Kontakt verhält sich bei einer thermodynamischen Zerrüttung anders als ein Band aus reinem Aluminium oder aus reinem Kupfer.

Der Sandwichaufbau des bändchenförmig ausgebildeten elektrischen Kontaktes zeichnet sich durch eine Schichtform aus. Der Sandwichaufbau umfasst mehrere, elektrisch gut leitende, dünn ausgebildete Kupferbleche im Bereich zwischen 50 µm und 200 µm - nachfolgend Kupferfolien genannt -, die mit einem Festphasendiffusionsprozess, nämlich Silbersintern, aufeinander gefügt sind. Diese Silbersinterschichten verhalten sich bei hohen Betriebstemperaturen plastisch, d.h. sind demzufolge in der Lage, lokal auftretende Spannungsspitzen drastisch zu reduzieren.

Durch Anwendung des Sinterns als Festphasendiffusionsprozesses können Vorschädigungen im Material bzw. im Halbleiter, wie sie beispielsweise beim Bonden durch eingebrachte Ultraschallleistung auftreten können, vermieden werden. Durch die bisher angewandte Methodik, d.h. das Einbringen von Ultraschallleistung, kann bei der Verwendung von Kupfer als Draht- oder Bändchenmaterial (bei höheren Kräften) das Prozessfenster und somit die herstellbaren Verbindungen fühlbar eingeschränkt werden. Durch den Einsatz des Sibersinterns als Festphasendiffusionsprozess können diese Nachteile vermieden werden. Durch die erfindungsgemäß vorgeschlagene Lösung kann eine Reduktion thermomechanisch induzierter Spannungen erreicht werden. Mindestens zwei Kupferschichten bilden den erwähnten Sandwichaufbau, wobei eine Verbindungsschicht aus Silber in Silbersintertechnik zwischen den mindestens zwei Kupferfolien gefertigt ist. Werden mehrere Kupferfolien und Sibersinterschichten, was sich nach der gewünschten Stromtragfähigkeit richtet, eingesetzt, kann ein elektrisches Bändchen von mehreren 100 µm, ja sogar bis zu einigen Millimetern Dicke aufgebaut werden.

Der Sandwichaufbau des elektrischen Bändchens aus Kupferfolien und Silbersinterschichten verhält sich im direkten Vergleich zu Aluminium-, Silber- oder Kupferbändern identischer Abmessungen bei Raumtemperatur (ϑ = 25°C) ähnlich steif und kann in fertigungstechnisch sehr günstiger Weise durch Stanzen oder Biegen vorkonfektioniert werden.

Treten höhere Temperaturen als Raumtemperatur (ϑ = 25°C) auf, verhalten sich die Silbersinterschichten, die zwischen den beiden Kupferfolien bzw. mehreren Kupferfolien angeordnet sind, plastisch. Dies führt dazu, dass die jeweils unterste Kupferschicht sich dem Ausdehnungsverhalten des Siliziums des Halbleiters anpasst und die darüber bzw. darunter liegende Silbersinterschicht gleichermaßen eine durch Temperaturwechsel bedingten thermische Verschiebung, d.h. Dehnung im Sandwichverbund kompensiert. Gegenüber einer Lösung mit lediglich einer Kupferfolie oder lediglich ein aufgesintertes Silberband, wird die erfindungsgemäß vorgeschlagene Lösung des Sandwichaufbaus des elektrischen Kontaktes auf mindestens zwei Fügestellen verteilt und somit signifikant reduziert.

Die Kompensation von thermisch induzierten Dehnungen in eventuell vorgesehenen weiteren Schichten des Sandwichaufbaus erfolgt nach dem gleichen Prinzip, zum Beispiel in einer nächst höher gelegenen Schicht, die weiter von der Kontaktierungsstelle entfernt liegt, wobei diese jedoch in geringerem Umfang durch das Ausdehnungsverhalten des Halbleiters (thermischer Ausdehnungskoeffizient von Silizium) beeinträchtigt wird. Je nach Schichtenanzahl kann die thermomechanisch induzierte Bewegung auf eine beliebige Anzahl von Fügestellen verteilt und somit was die Dauerhaltbarkeit der elektrischen Verbindung angeht, erheblich herabgesetzt werden.

### Vorteile der Erfindung

Die erfindungsgemäß vorgeschlagene Lösung zeichnet sich durch eine erheblich reduzierte thermomechanische Belastung am Halbleiter durch ein plastisches Verhalten des im Sandwichaufbau gefertigten elektrischen Bändchens bei höheren Temperaturen aus, so dass insgesamt gesehen die Spannungsspitzen, die sich im Sandwichaufbau des elektrischen Bändchens einstellen, drastisch reduziert werden. Durch die erfindungsgemäß vorgeschlagene Lösung kann durch den Einsatz des Sinterns als Festphasendiffusionsprozess der Bondprozess eingespart werden, der durch Werkzeuggeometrien und eingebrachte Schwingungen das Design des Drahtes oder Bandes begrenzt. Durch die Möglichkeit, größere Flächen auf dem Halbleiter zu fügen, reduziert sich des Weiteren der Übergangswiderstand vom elektrischen Bändchen auf den Halbleiter, was insgesamt gesehen die elektrischen Verluste herabsetzt. Durch die Möglichkeit, größere Flächen auf dem Halbleiterbauelement zu fügen, öffnet sich die Möglichkeit, eine höhere Verlustleistung durch das aufgesinterte Band abzuführen. Ferner erlaubt die Ausbildung einer größeren Fläche auf dem Halbleiter eine höhere Stromtragfähigkeit der Metallisierung auf dem Halbleiter, so dass die Dicke der Metallisierung, die bei hohen Stromdichten eine Limitierung darstellt (typische Schichtdicken 3 µm - 5 µm) hinsichtlich ihrer Bedeutung in den Hintergrund rückt.

Des Weiteren kann unter Anwendung der erfindungsgemäß vorgeschlagenen Lösung auf dem Halbleiter auf eine Entwicklung einer dickeren Sondermetallisierungsschicht verzichtet werden, die dazu eingesetzt wird, eine limitierte Stromtragfähigkeit einer Standardmetallisierung zu vergrößern, um die mechanischen Kräfte, die aus einem Bondprozess herrühren, aufzufangen. Dies ist durch die erfindungsgemäß vorgeschlagene Lösung obsolet geworden. Durch den Einsatz einer Silbersinterschicht aus Silber oder aus dotiertem Silber kann eine elektrische Kontaktierung geschaffen werden, die eine plastische Verformbarkeit aufweist. Der Grad der plastischen Verformbarkeit der Silbersinterschicht ist abhängig vom Spannungszustand im System, d.h. den Eigenspannungen, im System, die durch den Herstellungsprozess eingeprägt werden und dem Aufbau vorgegeben sind. Die Eigenspannungen, die durch den Herstellungsprozess induziert sind, hängen ab von Zeit und Temperatur, während die Eigenspannungen im System, die sich auf dessen Aufbau zurückführen lassen von der Schichtdicke und den beteiligten Materialien abhängig sind. Abhängig von den gewählten Herstellbedingungen verhält sich das System bei Raumtemperatur bis zu einer Belastung des silberhaltigen Materials von zum Beispiel 200 MPa elastisch, während bei einer höheren Belastung ein plastisches Verhalten auftritt, wobei die Belastung der beteiligten Werkstoffe nicht weiter ansteigt. Bei einem erhöhten Temperaturniveau, welches einem realen Einsatzfall des Halbleiters bei Abgabe von Verlustleistung entspricht, sinkt die Fließgrenze des silberhaltigen Materials, was die Spannungsbelastung absenkt. Beispielsweise halbiert sich die Fließgrenze bei einer Temperatur von 100°C auf zum Beispiel 100 MPa, bei einer Einsatztemperatur eines Siliziumhalbleiters von typischerweise 175°C kommt es zu einer Reduzierung auf ein Viertel der ursprünglichen Fließgrenze, d.h. etwa 50 MPa.

Somit können bei geringer Temperaturbelastungen, beispielsweise bei Vorliegen von Raumtemperatur, Unterschiede im thermischen Ausdehnungsverhalten durch ein elastisches Verhalten abgefangen werden. Dies bedeutet, dass der silberhaltige Werkstoff in geringerem Umfang zerrüttet, im Gegensatz zu einer Kontaktierung durch Aluminium- oder Kupferdraht beziehungsweise Kupferbänder. Bei höheren Temperaturen, etwa bei einer Annäherung des Temperaturniveaus an die Herstelltemperatur, erfolgt ein Abbau des Spannungszustandes bei gleichzeitiger Absenkung der Fließgrenze. Dies bedeutet, dass immer noch eine elastische Reserve vorgehalten wird, die deutlich über der von weichgeglühten Reinaluminium oder Reinkupfer liegt. Somit setzt die plastische Zerrüttung des silberhaltigen Werkstoffes in geringerem Umfang ein.

Hinsichtlich des Parameters Zeit beim Herstellungsprozess baut sich bei längeren Haltezeiten, insbesondere dann, wenn ein erhöhtes Temperaturniveau vorliegt, der Spannungszustand des silberhaltigen Materials ab.

### Kurze Beschreibung der Zeichnung

Anhand der Zeichnung wird die Erfindung nachstehend eingehender beschrieben.

Es zeigt
- Figur 1: einen Querschnitt durch eine bandförmig ausgebildete erfindungsgemäß elektrische Kontaktierung und
- Figur 2: eine Ausführungsmöglichkeit einer elektrischen Kontaktierung zwischen zwei Kontaktflächen.

### Ausführungsvarianten

Im Folgenden wird eine elektrische Kontaktierung 10, 12, 46 detaillierter beschrieben, die zwischen zwei Kontaktflächen 42, 44 ausgebildet ist. Bei den Kontaktflächen 42, 44 kann es sich beispielsweise unmittelbar um ein Halbleiterbauelement 44, wie zum Beispiel eine Diode, einen MOSFET, IGBT oder dergleichen handeln, oder um eine elektrisch leitfähige Kaschierung 42 oder unmittelbar über eine entsprechend konditionierte Ober- oder Unterseite eines Schaltungsträgers 40.

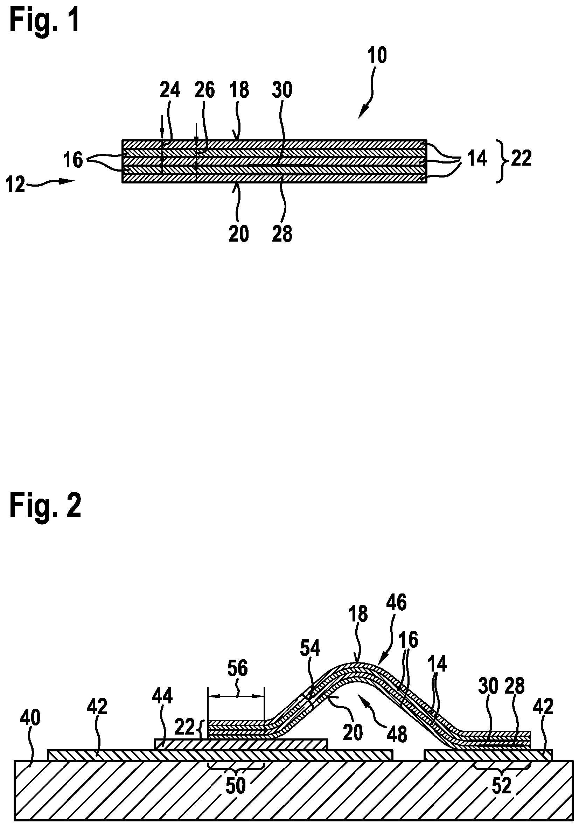

Der Darstellung gemäß Figur 1 ist zu entnehmen, dass eine dort dargestellte elektrische Kontaktierung 10 in Form eines Bändchens 12 ausgebildet ist. In einem Sandwichaufbau 22 sind - im Ausführungsbeispiel gemäß Figur 1 - drei Kupferfolien 14 und zwei, mittels einer Silbersintertechnik aufgebrachte Schichten 16, welche Silbersinterschichten darstellen. Die einzelnen Kupferfolien 14 bzw. die durch die Silbersintertechnik aufgebrachten Silbersinterschichten 16 sind übereinanderliegend ausgebildet und innerhalb des Sandwichaufbaus 22 in alternierender Abfolge übereinander geschichtet. Eine Oberseite des in Figur 1 dargestellten Sandwichaufbaus 22 der elektrischen Kontaktierung 10 ist durch Bezugszeichen 18 bezeichnet, während eine Unterseite des Sandwichaufbaus 22 durch Bezugszeichen 20 identifiziert ist.

Aus dem in Figur 1 dargestellten Querschnitt geht hervor, dass die Kupferfolien 14 in einer Schichtdicke 24 ausgeführt sind, die im Bereich zwischen 50 µm und 200 µm liegt. Jeweils zwei in einer derartigen Schichtdicke 24 ausgebildete Kupferfolien 14 sind über jeweils eine durch eine Silbersintertechnik aufgebrachte Silbersinterschichten 16, miteinander verbunden. Je nachdem, wie viele Kupferfolien 14 innerhalb des schichtförmigen Sandwichaufbaus 22 in alternierender Abfolge mit durch eine Silbersintertechnik aufgebrachte Silbersinterschichten 16 miteinander verbunden sind, kann der Sandwichaufbau 22 je nach gewünschter Stromtragfähigkeit eine Gesamtdicke von mehreren 100 µm bis zu einigen Millimetern aufweisen.

Im einfachsten Falle umfasst der Sandwichaufbau 22 eine Kupferfolie 14, die an Ober- und Unterseite jeweils durch beispielsweise eine Silbernitritschicht 16, d.h. durch Schichten, die durch Sintern als den Festphasendiffusionsprozess aufgebracht sind, versehen ist. Dadurch entstehen innerhalb des Sandwichaufbaus 22 Fügestellen 28, 30. Im fünf Schichten aufweisenden Sandwichaufbau 22 gemäß Figur 1 sind die Fügestellen 28, 30, die sich im Wesentlichen in horizontaler Richtung durch den Schichtaufbau erstrecken, dargestellt.

Der in Figur 1 dargestellte Sandwichaufbau 22 aus Kupferfolien 14 und durch eine Silbersinterschicht aufgebrachte Silbersinterschichten 16 verhält sich im direkten Vergleich zu Aluminium-, Silber- oder Kupferbändern gleiche Abmessungen bei Raumtemperatur (ϑ = 25°C) ähnlich steif und ist einfach in fertigungstechnisch günstiger Weise konfektionierbar. Der Sandwichaufbau 22 gemäß der Querschnittsdarstellung in Figur 1 kann beispielsweise durch Stanzen oder Biegen hergestellt werden.

Der schichtförmige Sandwichaufbau 22 zeichnet sich dadurch aus, dass die unterste der Kupferfolien 14, d.h. die auf der Oberseite eines Halbleiterbauelementes 44 aufgebrachte Kupferfolie 14 sich dem Ausdehnungsverhalten des Werkstoffs des Halbleiterbauelementes 44, d.h. dem Ausdehnungsverhalten von Silizium anpasst. Die plastische Verformbarkeit des Sandwichaufbaus 22 ist abhängig vom Spannungszustand im Sandwichaufbau 22, den Temperaturen sowie dem Faktor Zeit. So setzt beispielsweise bei einer Spannung von 200 MPa ohne dass der Faktor Zeit eine Rolle spielt, eine plastische Verformbarkeit ein, d.h. setzt Fließen ein.

Der Grad der plastischen Verformbarkeit des silberhaltigen Materials in Form einer Silbersinterschicht, ist abhängig vom Spannungszustand im System, d.h. den Eigenspannungen im System, die einerseits durch den Herstellungsprozess eingeprägt werden hinsichtlich Zeit und Temperatur und andererseits durch den Aufbau hinsichtlich Schichtdicke und beteiligter Materialien vorgegeben sind. Abhängig von den gewählten Herstellungsbedingungen verhält sich das System bei Raumtemperatur bis zu einer Belastung des silberhaltigen Materials von zum Beispiel 200 MPa elastisch, bei einer höheren Belastung tritt ein plastisches Verhalten auf, wobei die Belastung der beteiligten Werkstoff nicht weiter ansteigt.

Bei einer erhöhten Temperatur, welche dem realen Einsatzfall des Halbleiters entspricht, beispielsweise dann, wenn Verlustleistung abgegeben wird, sinkt die Fließgrenze des silberhaltigen Materials, was die Spannungsbelastung absenkt. Beispielsweise halbiert sich die Fließgrenze bei einer Temperatur von 100°C auf zum Beispiel 100 MPa, bei einer Einsatztemperatur eines Siliziumhalbleiters von typischerweise 175°C stellt sich eine Reduzierung der Fließgrenze auf ein Viertel der ursprünglichen Fließgrenze, d.h. auf einen Wert von etwa 50 MPa ein. Somit können bei geringerer Temperaturbelastung beispielsweise bei Raumtemperatur Unterschiede im thermischen Ausdehnungsverhalten durch ein elastisches Verhalten abgefangen werden, was bedeutet, dass der silberhaltige Werkstoff in wesentlich geringerem Umfang zerrüttet. Dies steht im krassen Gegensatz zu einer elektrischen Kontaktierung, die durch Aluminium oder durch Kupferdraht beziehungsweise Kupferband gebildet wird. Bei einem höheren Temperaturniveau, etwa bei einer Annäherung an die Herstelltemperatur erfolgt ein Abbau des Spannungszustandes bei gleichzeitiger Absenkung der Fließgrenze. Dies bedeutet, dass immer noch eine elastische Reserve vorgehalten wird, die deutlich über der von weichgeglühtem Reinaluminium oder Reinkupfer liegt. Somit setzt die plastische Zerrüttung des silberhaltigen Werkstoffes in geringerem Umfang ein.

Hinsichtlich des zeitlichen Parameters im Bezug auf den Herstellungsprozess ist zu erwähnen, dass bei längeren Haltezeiten, insbesondere bei einem höheren anliegenden Temperaturniveau, sich der Spannungszustand des Silbers abbaut.

Die über dieser Kupferfolie 14 liegende und die unter dieser Kupferfolie 14 liegende durch die Silbersintertechnik erzeugte Silbersinterschicht 16 kompensiert eine durch Temperaturwechsel bedingte thermische Dehnung, aufgrund ihrer plastischen Verformbarkeit bei höheren Temperaturen. Gegenüber einer elektrischen Kontaktierung, die lediglich eine Kupferfolie 14 oder eine Silbersinterschicht 16 aufweist, wird bei der thermisch induzierten Bewegung die mechanische Beanspruchung, d.h. die Ausdehnung auf mindestens zwei Fügestellen, eben jene sich in horizontaler Richtung erstreckenden Fügestellen 28 und 30 aufgeteilt, so dass die mechanischen Spannungsspitzen drastisch herabgesetzt werden. Je nach Anzahl der Fügestellen 18 bzw. 30 kann einerseits die Stromtragfähigkeit der elektrischen Kontaktierung 10 erhöht und andererseits die mechanische Belastung herabgesetzt werden.

Bei einem wie in Figur 1 dargestellten Sandwichaufbau 22 mit fünf oder mehr Schichten 14, 16, verhält sich die nächst höher gelegene Kupferfolie 14 in gleicher Weise, wobei diese jedoch aufgrund ihrer größeren Entfernung von der Temperaturquelle, nämlich der Kontaktstelle mit dem Halbleiterbauelement 44 hinsichtlich ihrer Beanspruchung in geringerem Maße vom Ausdehnungsverhalten des Werkstoffs des Halbleiterbauelements 44, d.h. vom Silizium abhängt. Umfasst der Sandwichaufbau 22 die in Figur 1 dargestellten beispielsweise fünf Schichten 14, 16, so stehen bereits zwei Fügestellen 28, 30 sowie eine weitere Fügestelle zur Verfügung, innerhalb derer die thermisch induzierten Relativbewegungen kompensierbar wären.

Der Darstellung gemäß Figur 2 ist eine bändchenförmig ausgebildete elektrische Kontaktierung zwischen zwei Kontaktflächen zu entnehmen.

Aus der Darstellung gemäß Figur 2 geht hervor, dass ein Schaltungsträger 40 beispielsweise zwei elektrisch leitfähige Kaschierungen 42 umfasst. Auf einer der elektrisch leitfähigen Kaschierungen 42 ist ein Halbleiterbauelement 44 aufgenommen, bei dem sich um eine Diode, um einen MOSFET oder um eine IGBT oder dergleichen handelt. Die Oberseite des Halbleiterbauelements 44 ist mittels eines bändchenförmigen elektrischen Kontaktes 46 mit einer der elektrisch leitfähigen Kaschierungen 42 elektrisch verbunden. In der Darstellung gemäß Figur 2 beschreibt der bändchenförmige elektrische Kontakt 46 einen Bogen 48. Über den bändchenförmig ausgebildeten elektrischen Kontakt 46 sind eine erste Kontaktierungsfläche 50, die sich an der Oberseite des Halbleiterbauelements 44 befindet und eine weitere, zweite Kontaktierungsfläche 52, die sich an der Oberseite einer der beiden elektrisch leitfähigen Kaschierungen 42 befindet, elektrisch miteinander verbunden. Bei dem bändchenförmigen elektrischen Kontakt 46 gemäß der Darstellung in Figur 2 handelt sich um einen Vier-Schicht-Sandwichaufbau 54. An einer jeden der Kontaktierungsflächen 50 bzw. 52 stehen größere Flächen zur Stromübertragung zur Verfügung bedingt durch eine erhöhte Kontaktierungslänge, siehe Position 56 in Figur 2.

Durch die Möglichkeit, größere Kontaktierungsflächen 50 bzw. 52 auszubilden, beispielsweise durch die Wahl einer erhöhten Kontaktierungslänge 56, reduziert sich der Übergangswiderstand vom bändchenförmig ausgebildeten Kontakt 46 zum Halbleiterbauelement 44, was zu einer Herabsetzung der elektrischen Verluste führt. Durch die Möglichkeit der Realisierung größerer Kontaktierungsflächen 50 bzw. 52 auf dem Halbleiterbauelement 44, die zum Fügen zur Verfügung stehen, kann eine höhere Verlustleistung durch eine aufgesinterte elektrische Kontaktierung 46 abgeführt werden. Ferner ist durch die vergrößerte Ausführung der Kontaktierungsflächen 50 bzw. 52 die Stromtragfähigkeit einer Metallisierung auf dem Halbleiterbauelement 44 nicht mehr der limitierende Faktor, wie dies bei hohen Stromdichten mit Schichtdicken von 3,2 µm bei bisherigen Ausführungsvarianten der Fall war.

Des Weiteren kann das elektrisch zu kontaktierende Halbleiterbauelement 44 in Gestalt einer Diode, eines MOSFET's oder eines IGBT's ohne eine extra dick auszubildende Sondermetallisierung ausgebildet werden. Mit einer dicken Sondermetallisierung wurde bisher eine limitierte Stromtragfähigkeit einer Standardmetallisierung vergrößert, um die aus einem Bondprozess, bei dem hohe mechanische Kräfte auftreten, resultierende mechanische Belastungen abzufangen.

Durch die erfindungsgemäß vorgeschlagene Lösung ist eine geringere thermomechanische Belastung am Halbleiterbauelement 44 durch plastisches Verhalten der durch den Festphasendiffusionsprozess erzeugten Zwischenschichten 16 zwischen den Kupferfolien 14 bei höherer Temperatur kompensierbar, so dass aufgrund der Herabsetzung des mechanischen Beanspruchungsniveaus bei entsprechenden Testzyklen eine lokale Temperaturerhöhung ohne Schaden eine daraus erfolgende Relativbewegung an der elektrischen Kontaktierung 10, 12, 46 ohne mechanische Auswirkungen auf die elektrische Kontaktierung bleibt, diese daher hinsichtlich ihrer Lebensdauer drastisch verbessert ist. Da ein thermomechanisches Wechselspiel und eine damit einhergehende Zerrüttung der Fügestelle zwischen den Werkstoffen Aluminium und Silizium zwangsläufig eine Erhöhung des elektrischen Widerstandes zur Folge hat, wodurch Verlustleistungen auftreten, kann die damit einhergehende lokale Temperaturerhöhung durch die erfindungsgemäß vorgeschlagene elektrische Kontaktierung in Form eines Sandwichaufbaus 22 bzw. 54 abgefangen werden, ohne dass diese Schaden nähme, oder ein Versagen der elektrischen Kontaktierung zwischen den beiden Kontaktflächen 42, 44 zu befürchten wäre.

## Patentansprüche

1. Elektrische Kontaktierung (10, 12, 46) in einer Halbleiteranordnung zwischen zwei Kontaktflächen (42, 44), wobei die elektrische Kontaktierung (10, 12, 46) bandförmig ausgeführt ist und als durch eine Schichtform ausgebildeter Sandwichaufbau (22, 54) mit mehreren elektrisch leitenden Kupferfolien (14) jeweils mit einer Schichtdicke zwischen 50 µm und 200 µm ausgeführt ist, **dadurch gekennzeichnet, dass** der Sandwichaufbau (22, 54) mindestens eine als Silbersinterschicht aufgebrachte Verbindungsschicht enthält, wobei die elektrisch leitenden Kupferfolien (14) mit der Verbindungsschicht aufeinander gefügt sind und dabei die Silbersinterschicht (16) jeweils als Verbindungsschicht zwischen zwei Kupferfolien (14) so ausgebildet ist, dass sie sich bei hohen Betriebstemperaturen plastisch verformen lässt.

2. Elektrische Kontaktierung (10, 12, 46) nach Anspruch 1,
**dadurch gekennzeichnet, dass**
die elektrische Kontaktierung zwei Kontaktflächen (42, 44) umfasst, wobei die Kontaktflächen
(42, 44) ein Halbleiterbauelement sind, beispielsweise eine Diode, ein MOSFET oder ein IGBT, oder eine elektrisch leitfähige Kaschierung (42) oder eine entsprechend konditionierte Ober- oder Unterseite eines Schaltungsträgers (40).

3. Verfahren zur Herstellung einer bändchenförmigen elektrischen Kontaktierung (10, 12, 46) zwischen zwei Kontaktflächen (42, 44) in einer Halbleiteranordnung, wobei ein schichtförmiger Sandwichaufbau (22, 54) umfassend mehrere elektrisch leitende Kupferfolien (14) jeweils mit einer Schichtdicke zwischen 50 µm und 200 µm, ausgebildet wird,
**dadurch gekennzeichnet, dass**
der Sandwichaufbau (22, 54) mindestens mit einer durch eine Silbersinterschicht aufgebrachten Verbindungsschicht ausgebildet wird, wobei die elektrisch leitenden Kupferfolien (14) miteinander gefügt werden und dabei die Silbersinterschicht (16) jeweils als Verbindungsschicht zwischen zwei Kupferfolien (14) so ausgebildet wird, dass sie sich bei hohen Betriebstemperaturen plastisch verformen lässt.

4. Verfahren gemäß Anspruch 3,
**dadurch gekennzeichnet, dass**
der Sandwichaufbau (22, 54) durch Stanzen oder Biegen als elektrisches Bändchen vorkonfektioniert wird.

## Claims

1. Electrical contact means (10, 12, 46) in a semiconductor arrangement between two contact surfaces (42, 44), wherein the electrical contact means (10, 12, 46) has a ribbon-shaped design and is designed as a layered sandwich structure (22, 54) having a plurality of electrically conductive copper foils (14) each having a layer thickness of between 50 µm and 200 µm, **characterized in that** the sandwich structure (22, 54) contains at least one connecting layer applied as a silver sinter layer,
wherein the electrically conductive copper foils (14) are joined together by the connecting layer and in doing so the silver sinter layer (16) is in each case formed as a connecting layer between two copper foils (14) such that it can be plastically deformed at high operating temperatures.

2. Electrical contact means (10, 12, 46) according to Claim 1,
**characterized in that**
the electrical contact means comprises two contact surfaces (42, 44), wherein the contact surfaces (42, 44) are a semiconductor component, for example a diode, a MOSFET or an IGBT, or an electrically conductive lamination (42) or a correspondingly conditioned upper or lower side of a circuit carrier (40).

3. Method for producing a ribbon-shaped electrical contact means (10, 12, 46) between two contact surfaces (42, 44) in a semiconductor arrangement, wherein a layered sandwich structure (22, 54) comprising a plurality of electrically conductive copper foils (14) each having a layer thickness of between 50 µm and 200 µm
is formed,
**characterized in that**
the sandwich structure (22, 54) is formed at least with one connecting layer applied by a silver sinter layer, wherein the electrically conductive copper foils (14) are joined together and in doing so the silver sinter layer (16) is in each case formed as a connecting layer between two copper foils (14) such that it can be plastically deformed at high operating temperatures.

4. Method according to Claim 3,
**characterized in that**
the sandwich structure (22, 54) is preassembled as an electrical ribbon by punching or bending.

## Revendications

1. Dispositif de mise en contact électrique (10, 12, 46) dans un agencement semi-conducteur entre deux surfaces de contact (42, 44), le dispositif de mise en contact électrique (10, 12, 46) étant réalisé sous forme de bande et étant conçu sous forme de structure sandwich (22, 54) formée par une configuration en couches comportant plusieurs feuilles de cuivre électriquement conductrices (14) ayant respectivement une épaisseur de couche comprise entre 50 µm et 200 µm, **caractérisé en ce que** la structure sandwich (22, 54) contient au moins une couche de liaison appliquée sous forme de couche de frittage d'argent,
les feuilles de cuivre électriquement conductrices (14) étant jointes les unes aux autres au moyen de la couche de liaison, et la couche de frittage d'argent (16) étant respectivement réalisée sous forme de couche de liaison entre deux feuilles de cuivre (14) de telle sorte qu'elle peut être déformée plastiquement à des températures de fonctionnement élevées.

2. Dispositif de mise en contact électrique (10, 12, 46) selon la revendication 1,
**caractérisé en ce que**
le dispositif de mise en contact électrique comprend deux surfaces de contact (42, 44), les surfaces de contact (42, 44) étant un composant semi-conducteur, par exemple une diode, un MOSFET ou un IGBT, ou une métallisation électriquement conductrice (42) ou une face supérieure ou inférieure conditionnée de manière correspondante d'un support de circuit (40).

3. Procédé de fabrication d'un dispositif de mise en contact électrique en forme de bande (10, 12, 46) entre deux surfaces de contact (42, 44) dans un agencement semi-conducteur, dans lequel une structure sandwich stratifiée (22, 54) comprenant une pluralité de feuilles de cuivre électriquement conductrices (14) ayant respectivement une épaisseur de couche comprise entre 50 µm et 200 µm,
est formée,
**caractérisé en ce que**
la structure sandwich (22, 54) est formée d'au moins une couche de liaison appliquée au moyen d'une couche de frittage d'argent, les feuilles de cuivre électriquement conductrices (14) étant jointes les unes aux autres et la couche de frittage d'argent (16) étant respectivement réalisée sous forme de couche de liaison entre deux feuilles de cuivre (14) de telle sorte qu'elle peut être déformée plastiquement à des températures de fonctionnement élevées.

4. Procédé selon la revendication 3,
**caractérisé en ce que**
la structure sandwich (22, 54) est préfabriquée sous forme de bande électrique par découpage à l'emporte-pièce ou pliage.
